# EUROPEAN PATENT APPLICATION

(11) **EP 4 250 343 A1**
(43) Date of publication of application: **27.09.2023**
(21) Application number: 23163290.2
(22) Date of filing: 21.03.2023
(51) Int. Cl.: H01L 21/677, E04B 5/14, E04B 5/32, E04F 15/12, E04B 5/43, F16F 15/02, H01L 21/67, E04F 15/024, E04F 15/02

(54) **SEMICONDUCTOR PROCESSING SYSTEM AND METHOD OF ASSEMBLY**

(30) Priority: 23.03.2022 US 202263322752 P
(71) Applicant: ASM IP Holding B.V., 1322 AP Almere (NL)
(72) Inventor: GARSSEN, Adriaan, 1322 AP Almere (NL)
(74) Representative: V.O.

(57) **Abstract**

A semiconductor processing system and a method for assembling such a system in a room of a semiconductor fabrication plant. The system comprises an equipment module and a pedestal. The equipment module may be movable over the pedestal to bring the equipment module in an end position and may have a plurality of stop surfaces. The method comprises placing the pedestal in the room, placing two stops on the pedestal and positioning the two stops relative to reference elements in the room, and connecting the positioned stops to the pedestal so that the positions thereof in the X-direction and Y-direction are fixed. The equipment module may be moved over the pedestal until the stop surfaces of the equipment module abut against the stops so as to position the equipment module in the X-direction and Y-direction relative to the reference elements.

## Description

### FIELD OF THE DISCLOSURE

The disclosure relates to a semiconductor processing system and a method for assembling the semiconductor processing system in a room of a semiconductor fabrication plant.

### BACKGROUND

Semiconductor processing systems may comprise at least one, but in many applications more than one equipment modules. For example, semiconductor processing systems comprising a vertical batch furnace may comprise a batch furnace module and a cassette stocker module. The batch furnace module may include at least one process chamber as well as a wafer handling space in which a wafer handling robot may be positioned which may transfer wafers from a wafer cassette to a wafer boat. The batch furnace module may include a boat transfer mechanism to transfer the wafer boat between a loading position and the process chamber. The stocker module may, for example, comprise stocker positions for wafer cassettes and a cassette handler which may transfer wafer cassettes between I/O-ports for wafer cassettes and stocker positions in a wafer cassette stock. The same or another cassette handler may additionally transfer wafer cassettes between stocker positions and a wafer cassette loading/unloading-position. The equipment modules of a semiconductor processing system may have a considerable mass. For example, a batch furnace module may have a mass of more than 5000 kg whereas a cassette stocker module may have a mass of more than 2000 kg. Generally, at a semiconductor fabrication plant of a client, these equipment modules are placed in a room, for example a clean room, on a pedestal which itself may also have a considerable mass of more than 500 kg. The pedestal may also support additional modules, for example one or more gas cabinets which may have a mass of 300 kg or more.

### SUMMARY

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

When the pedestal and the various equipment modules arrive at the semiconductor fabrication plant (hereafter FAB), they have to be assembled in a (clean) room where the semiconductor processing system will operate once assembled. When doing so, the various equipment modules may have to be positioned relative reference elements which have been defined by the client. A reference element may for example be a drop-off location of a transport system for semiconductor wafer cassettes and/or a reference line or reference points in the (clean) room in which the semiconductor processing system has to be set up.

It may be a challenge to position high mass equipment modules in the room of the FAB with sufficient accuracy. This challenge may even be even more daunting when the space around the semiconductor processing system is limited, for example caused by a neighboring system which may be at close distance so that a person cannot or can barely move between the semiconductor processing system which has to be assembled and the already present neighboring systems.

In order to alleviate the challenge, it may be an object to provide a method for assembling a semiconductor processing system in a room of a semiconductor fabrication plant. The semiconductor processing system may comprise at least one equipment module and a pedestal. A first equipment module of the at least one equipment module may be movable over the pedestal to bring the first equipment module in an end position. The first equipment module may have a plurality of stop surfaces which are fixedly connected with the first equipment module. The method may comprise placing the pedestal in the room; providing at least two stops; placing the at least two stops on the pedestal and positioning the at least two stops in a horizontal plane defined by an X-direction and a Y-direction relative to reference elements in the room. The thus positioned at least two stops may be connected to the pedestal so that the positions thereof in the X-direction and Y-direction may be fixed relative to the pedestal. The first equipment module may be moved over the pedestal until the stop surfaces of the first equipment module all abut against the stops so as to correctly position the first equipment module in the X-direction and Y-direction relative to the reference elements.

Additionally, an object of the disclosure may be to provide a semiconductor processing system which may comprise at least one equipment module and a pedestal. The pedestal and a first equipment module of the at least one equipment module may be configured to allow movement of the first equipment module over the pedestal to bring the first equipment module in an end position. The pedestal may comprise at least two stops which are positionable in a horizontal plane defined by an X-direction and a Y-direction relative to reference elements in a room of a semiconductor fabrication plant in which the semiconductor processing system may be placed. The at least two stops may be connectable to the pedestal so that the positions thereof in X-direction and Y-direction may be fixed relative to the pedestal. The first equipment module may comprise a plurality of stop surfaces which may be fixedly connected with the first equipment module and which may be configured for abutment against the at least two stops when the first equipment module is moved over the pedestal so as to correctly position the first equipment module in the X-direction and Y-direction relative to the reference elements.

With the method and the semiconductor processing system of the disclosure, the assembly of heavy and bulky equipment modules of a semiconductor processing system may be effected at the clients semiconductor fabrication plant more quickly and very accurately.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

Various embodiments are claimed in the dependent claims, which will be further elucidated with reference to an example shown in the figures. The embodiments may be combined or may be applied separate from each other.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE FIGURES

While the specification concludes with claims particularly pointing out and distinctly claiming what are regarded as embodiments of the invention, the advantages of embodiments of the disclosure may be more readily ascertained from the description of certain examples of the embodiments of the disclosure when read in conjunction with the accompanying drawings, in which:
Fig. 1 shows a perspective top view of an example of a pedestal;
Fig. 2 shows detail II of Fig. 1;
Fig. 3 shows a perspective view of an alignment jig;
Fig. 4 shows the alignment jig while aligning two stops on the pedestal;
Fig. 5 shows a perspective bottom view of the pedestal with the alignment jig;
Fig. 6 shows detail VI from Fig. 5;
Fig. 7 shows a top view of the pedestal with alignment jig;
Fig. 8 shows detail VIII from Fig. 7;
Fig. 9 shows a perspective view of a first equipment module, e.g., a process of being placed and positioned on the pedestal;
Fig. 10 shows detail X from Fig. 9
Fig. 11 shows detail XI from Fig. 9
Fig. 12 shows a perspective bottom view of a second equipment module, e.g., a vertical batch furnace module;
Fig. 13 shows detail XIII from Fig. 12;
Fig. 14 shows detail XIV from Fig. 12;
Fig. 15 shows the second equipment module being placed and positioned on the pedestal;
Fig. 16 shows detail XVI of Fig. 15;
Fig. 17 shows detail XVII of Fig. 15;
Fig. 18 shows the assembled semiconductor processing system from a first viewpoint;
Fig. 19 shows tail XIX of Fig. 18;
Fig. 20 shows the assembled semiconductor processing system from a second viewpoint;
Fig. 21 shows the first cylindrical pin in abutment with the stop surfaces; and
Fig. 22 shows the second cylindrical pin in abutment with the stop surfaces.

### DETAILED DESCRIPTION

In this application similar or corresponding features are denoted by similar or corresponding reference signs. The description of the various embodiments is not limited to the examples shown in the figures and the reference numbers used in the detailed description and the claims are not intended to limit the description of the embodiments, but are included to elucidate the embodiments.

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below. The illustrations presented herein are not meant to be actual views of any particular material, structure, or device, but are merely idealized representations that are used to describe embodiments of the disclosure.

As used herein, the term "wafer" may refer to any underlying material or materials that may be used, or upon which, a device, a circuit, or a film may be formed.

Before describing the method and the advantages which may be obtained with applying the method, first the semiconductor processing system disclosed herein will be described with reference to the figures.

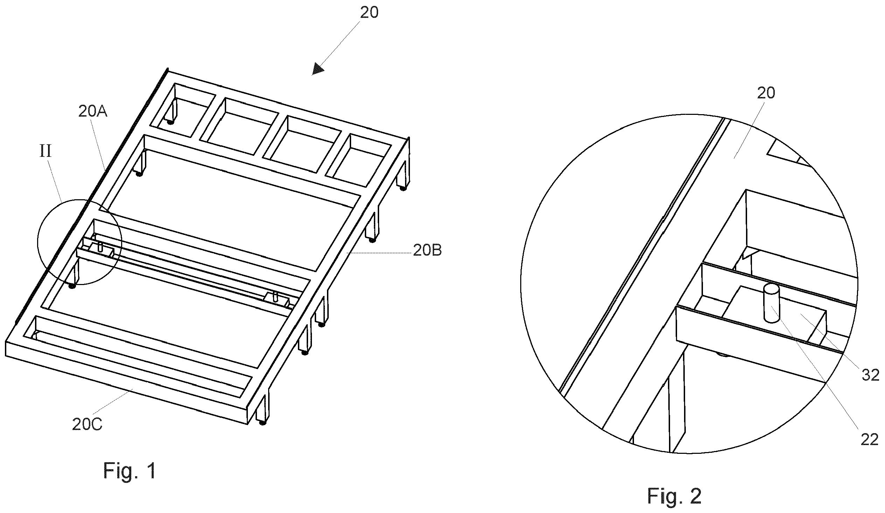

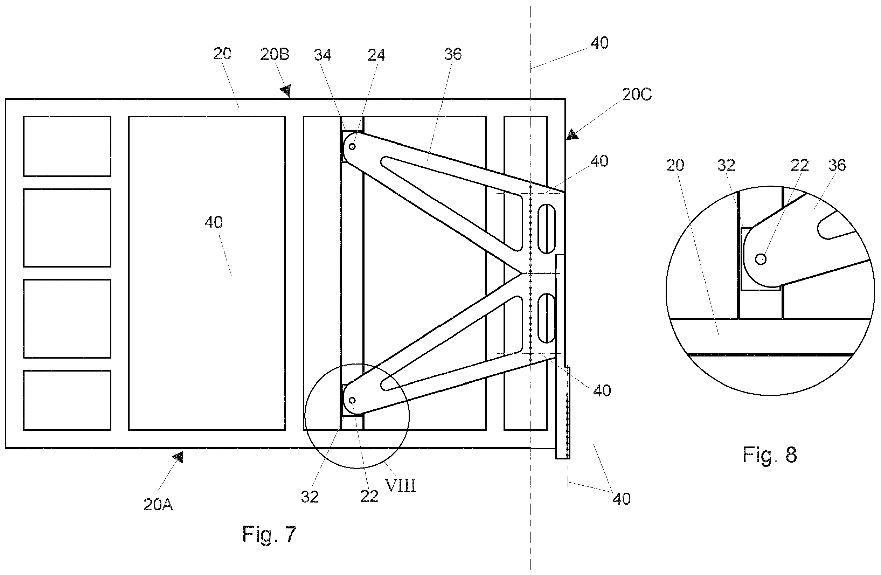

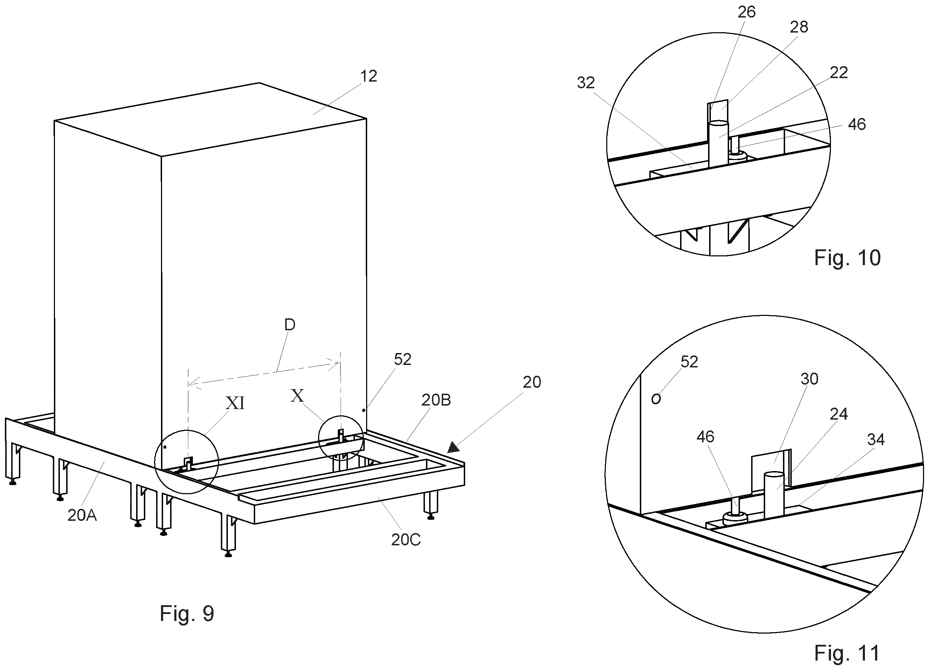

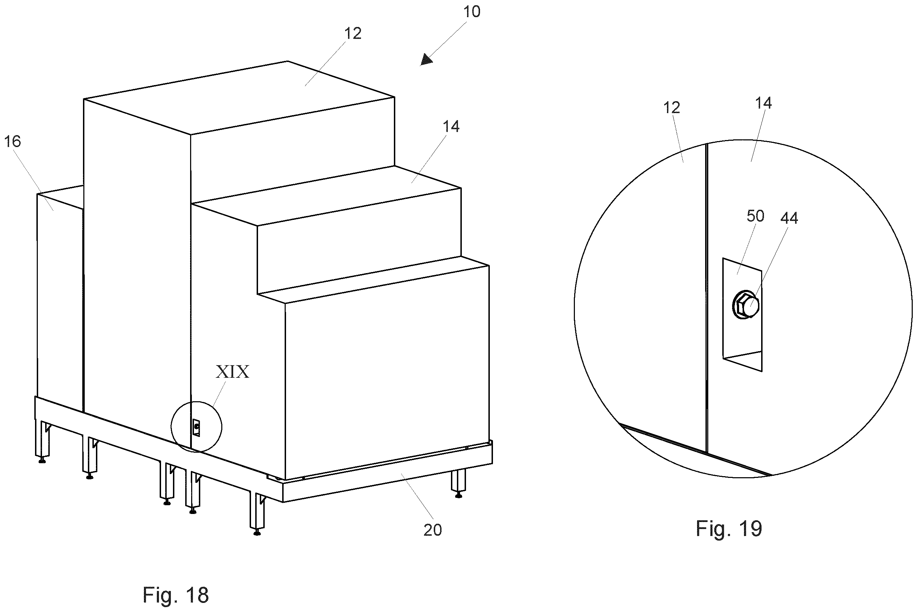

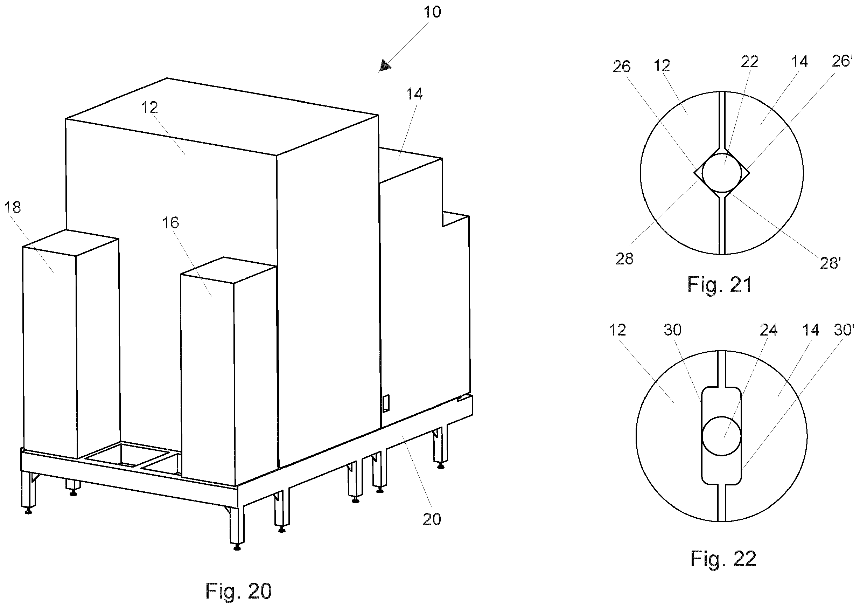

In the most general terms, the present disclosure may provide a semiconductor processing system 10 that may comprise at least one equipment module 12, 14 and a pedestal 20. An example of such a semiconductor processing system 10 is shown in Figs. 18 and 20. An example of the pedestal 20 is shown in Figs. 1, 2, 4-9, 15, 18 and 20. The pedestal 20 and a first equipment module 12 of the at least one equipment module may be configured to allow movement of the first equipment module 12 over the pedestal 20 to bring the first equipment module 12 in an end position. The pedestal 20 may comprise at least two stops 22, 24 (see Figs. 2, 4, 8, 10, 11, 16, 17, 21, 22) which may be positionable in a horizontal plane defined by an X-direction and a Y-direction relative to reference elements 40 (see Fig. 7) in a room of a semiconductor fabrication plant in which the semiconductor processing system 10 may be placed. The at least two stops 22, 24 may be connectable to the pedestal 20 so that the positions thereof in X-direction and Y-direction may be fixed relative to the pedestal 20. The first equipment module 12 may comprise a plurality of stop surfaces 26, 28, 30, (see Figs. 10, 11, 21, 22). Stop surfaces 26, 28, 30 may be fixedly connected with the first equipment module 12. Stop surfaces 26, 28, 30 may be configured for abutment against the at least two stops 22, 24 when the first equipment module 12 is moved over the pedestal 20 so as to correctly position the first equipment module 12 in the X-direction and Y-direction relative to the reference elements 40.

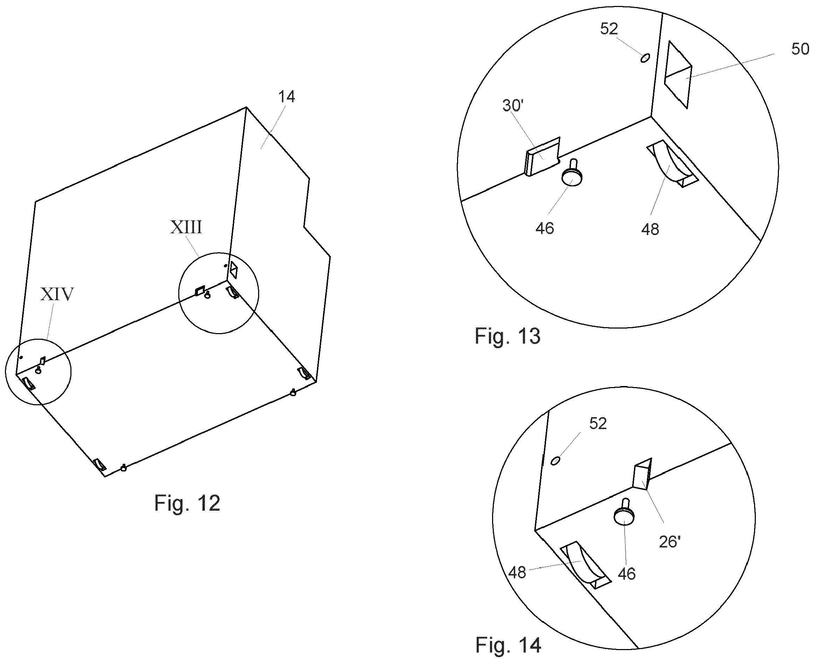

In an embodiment, an equipment module 12, 14 may include wheels 48 (see Figs. 12-14) with which the equipment module 12, 14 may be moved over a frame part of the pedestal 20. Instead of wheels 48, low friction surfaces, e.g., low friction pads, may also be feasible to provide a smooth movability of the equipment modules 12, 14 over the pedestal 20.

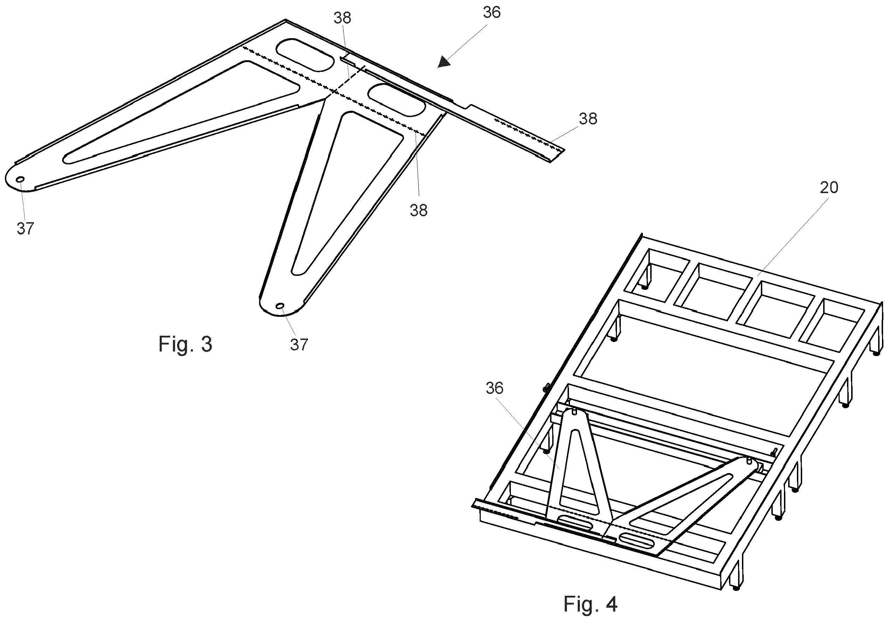

In an embodiment, the semiconductor processing system 10 may additionally comprise an alignment jig 36 (see Figs. 3-8) having reference marks 38 (see Fig. 3) and having stop engagement surfaces 37. In the example shown in the figures, the stop engagement surfaces 37 are formed by circular holes in which the stops 22, 24 snugly fit. The stops 22, 24 may be positioned relative to the reference elements 40 in X-direction and Y-direction using the alignment jig 36.

In an embodiment, of which an example is shown in the figures, each stop 22, 24 of the at least two stops 22, 24 may comprise a vertically extending cylindrical pin 22, 24. Alternatively, the at least two stops 22, 24 may also be embodied as balls or spheres.

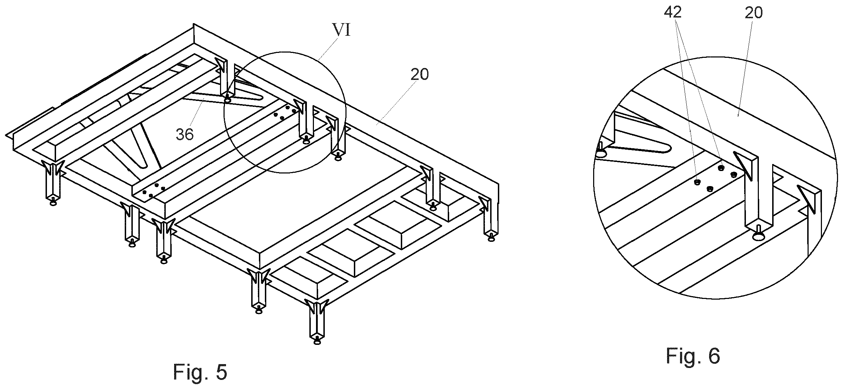

In embodiment, each cylindrical pin may be mounted in a mounting block 32, 34 (see Figs. 1, 2, 7, 8, 10, 11) which is associated with the respective cylindrical pin 22, 24 and which may be supported by the pedestal 20 and connected to the pedestal 20 by bolts 42 (see Figs. 5 and 6). In such an embodiment, the fixing of the stop 22, 24 may be effected by fixing the mounting blocks 32, 34 to the pedestal 20. In this embodiment, cylindrical pins 22, 24 may be removable from the mounting block 32, 34 temporarily, but after insertion again into the mounting blocks 32, 34 their positions are again fixed in X-direction and Y-direction relative to the pedestal 20 and the external reference elements 40.

In an embodiment, the plurality of stop surfaces 26, 28, 30 of the first equipment module 12 may comprise a first vertically extending stop surface 26 and a second vertically extending stop surface 28 which together bound a V-shaped space in which a first stop 22 of the at least two vertically extending stops 22, 24 can be received for abutment against both the first and the second vertically extending stop surfaces. The plurality of stop surfaces 26, 28, 30 of the first equipment module 12 may additionally comprise a third vertically extending stop surface 30 which may be spaced at a distance D (see Fig. 9) from an intersection line of the first and second vertically extending stop surfaces 26, 28. The third vertically extending stop surface 30 may be positioned on the first equipment module 12 for abutment against a second stop 24 of the at least two vertically extending stops 22, 24.

In an embodiment, said distance D, which in practice also may be the distance between the first and the second stop 22, 24, may be at least 500 mm. A distance D of that magnitude may provide a stable positioning of the first equipment module 12.

In an embodiment, a first stop 22 of the at least two stops 22, 24 may be adjacent a first lateral side 20A (see Fig. 7 and 9) of the pedestal 20 and a second stop 24 of the at least two stops 22, 24 may adjacent a second lateral side 20B (see Fig. 7 and 9) of the pedestal 20 which is opposite the first lateral side.

Under "adjacent a first/second lateral side," one may understand at a distance from the lateral side of less than 250 mm.

In an embodiment, the at least one equipment module of the semiconductor processing system 10 may comprise a second equipment module 14 (see Fig. 12-20). The second equipment module 14 may have a plurality of stop surfaces 26', 28', 30' (see Figs. 13, 14, 16, 17, 21, 22) which may be fixedly connected with the second equipment module 14 and which may be configured for abutment against the at least two stops 22, 24 when the second equipment module 14 is moved over the pedestal 20 so as to correctly position the second equipment module 14 in the X-direction and Y-direction relative to the reference elements 40.

In an embodiment, of which an example is shown in the figures, the at least two stops 22, 24 may be positioned on the pedestal 20 between the first equipment module 12 and the second equipment module 14.

Optionally, the stops 22, 24, may be removably mounted in the mounting blocks 32, 34 even after they have been accurately positioned and the mounting blocks 32 have been fixed to the pedestal 20. In that way, both equipment modules 12, 14 may be placed on the pedestal 20 from a first end 20C (see Fig. 9). For example, when the stops 22, 24 are approximately in a central part of the pedestal 20, the first equipment module 12 may be moved from that first end 20C of the pedestal 20 over the central part of the pedestal 20. After that, the stops 22, 24 may be placed in the mounting blocks 32, 34 of which the position has already been fixed and the second equipment module 14 may be moved from the first end 20C of the pedestal towards the stops 22, 24.

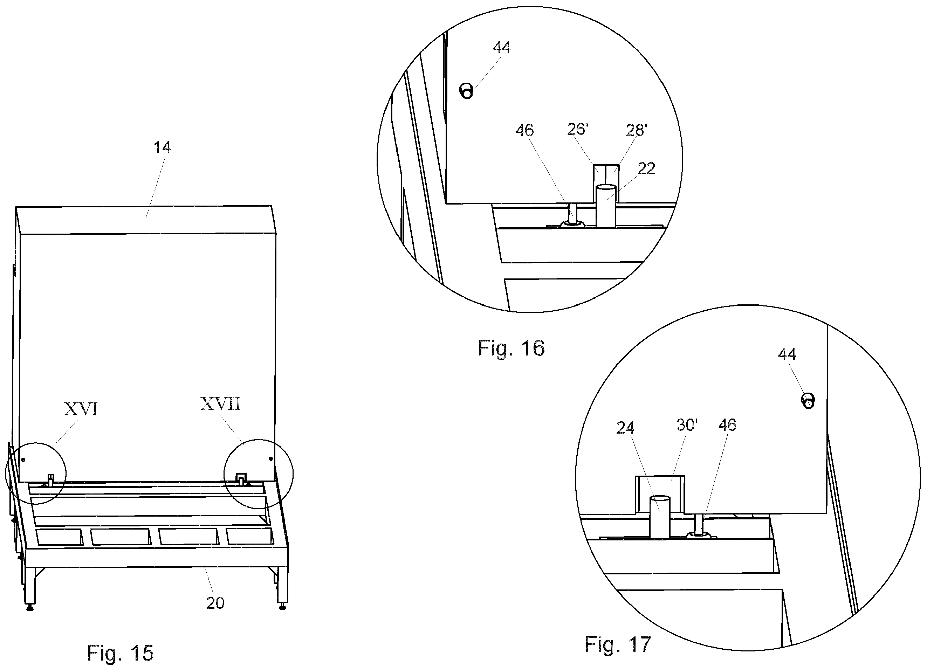

In an embodiment, the first equipment module 12 and the second equipment module 14 may be connected to each other by at least one or two bolts 44 (see Figs. 16, 17, 19) extending in a horizontal direction and which may have pulled the first and second equipment module 14 towards each other so that the stop surfaces 26, 28, 30, 26', 28' 30' of both the first equipment module 12 and the second equipment module 14 abut against the at least two stops 22, 24.

In the example shown in the figures, the second equipment module 14 comprises two chambers 50 in its lateral sides (see Fig. 19) via which the bolts 44 are received in holes (see Figs. 16 and 17). In the example, the bolts 44 engage in two threaded holes 52 (see Figs. 9 and 11) in the first equipment module. It is clear that many variations are possible to connect the first equipment module 12 with the second equipment module 14 with two horizontally extending bolts 44. The chambers 50 may also be provided on the bottom side of the equipment module 14 or in the first equipment module 12. Preferably, the bolts 44 are positioned relatively close to the stop surfaces 26, 28 and 30, e.g., at a distance of less than 100 mm.

In an embodiment, of which an example is shown in the figures, the first equipment module 12 may be a vertical batch furnace module. The second equipment module 14 may be a semiconductor cassette stocker module.

The disclosure may also relate to a method for assembling a semiconductor processing system 10 in a room of a semiconductor fabrication plant. The method may comprise:
placing the pedestal 20 in the room (see Figs. 1 and 2);
providing at least two stops 22, 24;
placing the at least two stops 22, 24 on the pedestal 20 and positioning the at least two stops 22, 24 in a horizontal plane defined by an X-direction and a Y-direction relative to reference elements 40 in the room (see Figs. 4, 7, 8);
connecting the thus positioned at least two stops 22, 24 to the pedestal 20 so that the positions thereof in X-direction and Y-direction may be fixed relative to the pedestal 20 (see Figs 5, 6);
moving the first equipment module 12 over the pedestal 20 until the stop surfaces 26, 28, 30 of the first equipment module 12 all abut against the stops 22, 24 so as to correctly position the first equipment module 12 in the X-direction and Y-direction relative to the reference elements 40 (see Fig. 9).

In an embodiment, the method may comprise providing an alignment jig 36 having reference marks 38 and having stop engagement surfaces 37 (see Fig. 3). The positioning of the at least two stops 22, 24 in the horizontal may be effected by positioning the alignment jig 36 such that the reference marks 38 thereon are aligned relative to the reference elements 40 (see Figs. 4 and 7) and that by doing so, the at least two stops 22, 24 which may be engaged by the engagement surfaces 37 of the alignment jig 36 may be moved and positioned in the X-direction and Y-direction in the horizontal plane.

In an embodiment, the reference elements 40 (see Fig. 7) may be one or more customer appointed reference points in the room, in particular, a drop-off location of a transport system for semiconductor wafer cassettes, for example of an overhead wafer cassette transport system, and/or a reference line or reference points defined by, for example, the position of a neighboring system.

As described above with reference to the system, each stop of the at least two stops 22, 24 may comprise a vertically extending cylindrical pin and each cylindrical pin may be mounted in a mounting block 32, 34 which is associated with the respective cylindrical pin 22, 24 (see Figs. 1, 2, 7, 8, 10, 11). During the positioning of the at least two stops 22, 24 relative to the reference elements 40 in the room, the mounting blocks 32 may be slid over the pedestal 20. When the at least two stops 22, 24 are in a desired position relative to the reference elements 40, the mounting blocks 32 may be connected to the pedestal 20 by at least one bolt 42 (see Figs. 5 and 6). By that, the two stops 22, 24 are positioned and fixed, that is fixed in the X-Y plane (i.e., in the X-direction and Y-direction) relative to the pedestal 20 and also fixed relative to the reference elements 40.

This fixed connection in the desired position, does not exclude, in an embodiment, that each cylindrical pin 22, 24 may be removably mounted in a cylindrical hole in an associated one of the mounting blocks 32, 34. In such an embodiment, the mounting blocks 32, 34 define the exact fixed position of the cylindrical pins 22, 24. The removability of the cylindrical pins 22, 24 after fixing their position in the X-direction and Y-direction by virtue of the fixed connection of the mounting blocks 32, 34 to the pedestal 20 may, as described above, be helpful when an equipment module 12, 14 has to be moved from one end 20C of the pedestal 20 to the other end of the pedestal 20 and thereby pass over the mounting blocks 32 without being hindered by the cylindrical pins 22, 24.

As described with reference to the semiconductor processing system, the plurality of stop surfaces 26, 28, 30 of the first equipment module 12 may comprise a first vertically extending stop surface 26, a second vertically extending stop surface 28 which, together with the first stop surface 26 may bound a V-shaped space, as well as a third vertically extending stop surface 30 which is spaced at a distance D from an intersection line of the first and second vertically extending stop surfaces 26, 28.

In an embodiment, the method may comprise that during movement of the first equipment module 12 over the pedestal 20, a first stop 22 of the at least two vertically extending stop 22, 24 may be received in the V-shaped space and may finally abut against both the first and the second vertically extending stop surfaces 26, 28 (see Fig. 10). Additionally, the method may comprise that during movement of the first equipment module 12 over the pedestal 20, the third vertically extending stop surface 30 may be moved towards the second stop 24 and finally the second stop 24 may abut against the third vertically extending stop surface 30 as well (see Fig. 11).

As described with reference to the semiconductor processing system 10, the at least one equipment module of the semiconductor processing system 10 may comprise a second equipment module 14. The second equipment module 14 may also have a plurality of stop surfaces 26', 28', 30' which are fixedly connected with the second equipment module 14 and which are configured for cooperation with the at least two stops 22, 24. With such an embodiment of the semiconductor processing system 10, an embodiment of the method may comprise moving the second equipment module 14 over the pedestal 20 until the stop surfaces 26', 28', 30' of the second equipment module 14 all abut against the stops 22, 24 so as to correctly position the second equipment module 14 in the X-direction and Y-direction relative to the reference elements 40 (see Fig. 15-17 in which for the sake of clarity the first equipment module 12 is not shown).

When the semiconductor processing system 10 is of the embodiment in which the at least two stops 22, 24 are positioned on the pedestal 20 between the first equipment module 12 and the second equipment module 14, an embodiment of the method may comprise that the moving of the first equipment module 12 and the second equipment module 14 may be effected by pulling or pushing the first equipment module 12 and second equipment module 14 towards each other until the stop surfaces 26, 28, 30, 26', 28', 30' of both the first equipment module 12 and the second equipment module 14 abut against the at least two stops 22, 24.

In a further elaboration of this embodiment, the pulling or pushing towards each other of the first and second equipment modules 12, 14 may be effected with at least two substantially horizontally extending bolts 44 (see Figs. 16-19) which may connect the first equipment module 12 with the second equipment module 14.

The action of pulling or pushing the first equipment module 12 and the second equipment module 14 together may be done after feet 46, (see Figs. 10, 11, 13, 14, 16, 17) have been lowered so that the equipment modules 12, 14 may no longer be supported by the wheels 48 but, instead thereof, may be supported by the feet 46.

In an embodiment, the method may comprise that after positioning the at least one equipment module in the X-direction and Y-direction, the at least one equipment module 12, 14 is vertically positioned in Z-direction. A vertical levelling may be effected by changing the height of the feet 46. The accuracy for the height levelling may, for example, be approximately ± of 0.1 mm which can be obtained by turning the feet 46 which have a threaded stem. After levelling, the equipment modules may optionally be connected with the pedestal 20.

As explained above, after placement of the pedestal 20 in the room of the semiconductor fabrication plant, first the stops 22, 24 are placed on the pedestal and accurately positioned in X- and Y-direction in relation to external reference elements 40. This accurately positioning of the stops 22, 24 is relatively easy because the weight of the stops 22, 24 is such that they can be moved by hand. To make the job even easier, the alignment jig 36 may be used. Once positioned, the stops 22, 24, at least their positions in X-direction and Y-direction may be fixed relative to the pedestal 20. After that, the equipment modules 12 and 14 may be placed on the pedestal 20 and moved until the stop surfaces 26, 28, 30, 26', 28', 30' abut against the stops 22,24. In that situation, the equipment modules are "automatically" aligned with the external reference elements 40 as well. In the end phase of the movement of the equipment modules 12, 14, the positioning is, in fact, achieved by the guidance of the stop surfaces 26, 28, 30, 26', 28', 30' along the stops 22, 24. The force needed for the movement of the first equipment module 12 and the optional second equipment module 14 only has to be generally in the correct direction and the interaction between the stop surfaces 26, 28, 30, 26', 28', 30' and the stops 22, 24 does the accurate positioning. Thus, assembling the heavy and bulky equipment modules 12, 14 of a semiconductor processing system 10 can be effected at the clients semiconductor fabrication plant more quickly and very accurately.

Not all equipment modules of a semiconductor processing system 10 have to be positioned accurately on the pedestal 20. In the example shown in Figs. 18 and 20 two additional modules are shown which may, for example, be gas cabinets 16, 18. The position of these additional modules may not be critical and the mass thereof may be considerably less than the mass of the first equipment module 12 and the second equipment module 14 of the example shown in the figures. Thus, for these types of modules the placement on the pedestal 20 can be done in a conventional manner.

Although illustrative embodiments of the present invention have been described above, in part with reference to the accompanying drawings, it is to be understood that the invention is not limited to these embodiments. Variations to the disclosed embodiments can be understood and effected by those skilled in the art in practicing the claimed invention, from a study of the drawings, the disclosure, and the appended claims.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this description are not necessarily all referring to the same embodiment.

Furthermore, it is noted that particular features, structures, or characteristics of one or more of the various embodiments which are described above may be used implemented independently from one another and may be combined in any suitable manner to form new, not explicitly described embodiments. The reference numbers used in the detailed description and the claims do not limit the description of the embodiments, nor do they limit the claims. The reference numbers are solely used to clarify.
- 10.: Semiconductor processing system
- 12.: First equipment module
- 14.: Second equipment module
- 16.: First gas cabinet
- 18.: Second gas cabinet
- 20.: Pedestal
- 20A.: First lateral side of pedestal
- 20B.: Second lateral side of pedestal
- 20C.: First end of pedestal
- 22.: First stop embodied as first cylindrical pin
- 24.: Second stop embodied as second cylindrical pin
- 26.: First stop surface of first equipment module
- 28.: Second stop surface of first equipment module
- 30.: Third stop surface of first equipment module
- 26'.: First stop surface of second equipment module
- 28'.: Second stop surface of second equipment module
- 30'.: Third stop surface of second equipment module
- 32.: Mounting block for first stop
- 34.: Mounting block for second stop
- 36.: Alignment jig
- 37.: Alignment jig holes
- 38.: Reference marks on alignment jig
- 40.: Reference elements in the room
- 42.: Bolts for connecting the mounting blocks to the pedestal
- 44.: Bolts for connecting the first and the second equipment modules
- 46.: Feet for supporting an equipment module
- 48.: Wheels for supporting an equipment module
- 50.: Chamber
- 52.: Threaded hole for bolt for connecting the first and second modules
- D.: Distance between first and second stop

## Claims

1. A method for assembling a semiconductor processing system in a room of a semiconductor fabrication plant, the semiconductor processing system comprising at least one equipment module and a pedestal, a first equipment module of the at least one equipment module being movable over the pedestal to bring the first equipment module in an end position, the first equipment module having a plurality of stop surfaces, the method comprising:
placing the pedestal in the room;
providing at least two stops;
placing the at least two stops on the pedestal and positioning the at least two stops in a horizontal plane defined by an X-direction and a Y-direction relative to reference elements in the room;
connecting the at least two stops to the pedestal so that the positions of the at least two stops in the X-direction and the Y-direction are fixed relative to the pedestal; and
moving the first equipment module over the pedestal until the stop surfaces of the first equipment module abut against the least two stops so as to position the first equipment module in the X-direction and the Y-direction relative to the reference elements.

2. The method of claim 1, further comprising:
providing an alignment jig having reference marks and having stop engagement surfaces;
wherein the positioning of the at least two stops in the horizontal plane is effected by positioning the alignment jig such that the reference marks thereon are aligned relative to the reference elements and that by doing so, the at least two stops which are engaged by the engagement surfaces of the alignment jig are moved and positioned in the X-direction and the Y-direction in the horizontal plane.

3. The method of claim 1 or 2, wherein the reference elements are one or more reference points in the room.

4. The method according to any one of claims 1-3, wherein each stop of the at least two stops comprises a vertically extending cylindrical pin.

5. The method according to claim 4, wherein each cylindrical pin is mounted in a mounting block which is associated with the respective cylindrical pin and which is slideably supported by the pedestal and which is connectable to the pedestal by at least one bolt, wherein during the positioning of the at least two stops relative to the reference elements, the mounting blocks are slid over the pedestal, wherein, in response to the at least two stops being in a desired position relative to the reference elements, the mounting blocks are connected to the pedestal by at least one bolt.

6. The method according to any one of claims 4-5, wherein the plurality of stop surfaces of the first equipment module comprise:
a first vertically extending stop surface and a second vertically extending stop surface which together bound a V-shaped space in which a first one of the at least two vertically extending cylindrical pins is receivable for abutment against both the first and the second vertically extending stop surfaces; and
a third vertically extending stop surface which is spaced at a distance from an intersection line of the first and second vertically extending stop surfaces, wherein the third vertically extending stop surface is positioned on the first equipment module for abutment against a second one of the at least two vertically extending cylindrical pins,
wherein a first of the at least two vertically extending cylindrical pins is received in the V-shaped space and finally abuts against both the first and the second vertically extending stop surfaces, and wherein a second of the at least two vertically extending cylindrical pins abuts against the third vertically extending stop surface.

7. The method according to any one of the preceding claims, wherein the at least one equipment module of the semiconductor processing system comprises a second equipment module, the second equipment module having a plurality of stop surfaces which are configured for cooperation with the at least two stops, wherein the method further comprises:
moving the second equipment module over the pedestal until the stop surfaces of the second equipment module abut against the at least two stops so as to position the second equipment module in the X-direction and Y-direction relative to the reference elements.

8. The method according to claim 7, wherein the at least two stops are positioned on the pedestal between the first equipment module and the second equipment module and wherein the moving of the first equipment module and the second equipment module is effected by pulling or pushing the first equipment module and the second equipment module towards each other until the stop surfaces of both the first equipment module and the second equipment module abut against the at least two stops.

9. The method according to claim 8, wherein the pulling or pushing the first equipment module and the second equipment module towards each other is effected with at least two substantially horizontally extending bolts which connect the first equipment module with the second equipment module.

10. The method according to any one of the preceding claims, wherein after positioning the at least one equipment module in the X-direction and the Y-direction, the at least one equipment module is vertically positioned in a Z-direction and optionally after that coupled to with the pedestal.

11. A semiconductor processing system comprising at least one equipment module and a pedestal, wherein the pedestal and a first equipment module of the at least one equipment module are configured to allow movement of the first equipment module over the pedestal to bring the first equipment module in an end position, wherein the pedestal comprises at least two stops which are positionable in a horizontal plane defined by an X-direction and a Y-direction relative to reference elements in a room of a semiconductor fabrication plant in which the semiconductor processing system is placed, wherein the at least two stops are connectable to the pedestal so that the positions thereof in the X-direction and the Y-direction are fixed relative to the pedestal, wherein the first equipment module comprises a plurality of stop surfaces which are configured for abutment against the at least two stops in response to the first equipment module being moved over the pedestal so as to position the first equipment module in the X-direction and the Y-direction relative to the reference elements.

12. The semiconductor processing system according to claim 11, further comprising an alignment jig having reference marks and having stop engagement surfaces, wherein the stops are positioned relative to the reference elements in the X-direction and the Y-direction using the alignment jig.

13. The semiconductor processing system according to claim 11 or 12, wherein each stop of the at least two stops comprises a vertically extending cylindrical pin.

14. The semiconductor processing system according to claim 13, wherein each cylindrical pin is mounted in a mounting block which is associated with the respective cylindrical pin and which is supported by the pedestal and coupled to the pedestal by at least one bolt.

15. The semiconductor processing system according to claim 14, wherein each cylindrical pin is removably mounted in a cylindrical hole in the associated mounting block.

16. The semiconductor processing system according to any one of claims 11-15, wherein the plurality of stop surfaces of the first equipment module comprises:
a first vertically extending stop surface and a second vertically extending stop surface, which together bound a V-shaped space in which a first one of the at least two stops is receivable for abutment against both the first and the second vertically extending stop surfaces; and
a third vertically extending stop surface which is spaced at a distance from an intersection line of the first and the second vertically extending stop surfaces, wherein the third vertically extending stop surface is positioned on the first equipment module for abutment against a second one of the at least two stops.

17. The semiconductor processing system according to any one of claims 11-16, wherein a first one of the at least two stops is adjacent a first lateral side of the pedestal and wherein a second one of the at least two stops is adjacent a second lateral side of the pedestal which is opposite the first lateral side.

18. The semiconductor processing system according to any one of claims 11-17, wherein the at least one equipment module of the semiconductor processing system comprises a second equipment module, the second equipment module having a plurality of stop surfaces which are configured for abutment against the at least two stops in response to the second equipment module being moved over the pedestal so as to position the second equipment module in the X-direction and the Y-direction relative to the reference elements.

19. The semiconductor processing system according to claim 18, wherein the at least two stops are positioned on the pedestal between the first equipment module and the second equipment module.

20. The semiconductor processing system according to claim 19, wherein the first equipment module and the second equipment module are coupled to each other by at least one bolt extending in a horizontal direction and which have pulled or pushed the first equipment module and the second equipment module towards each other so that the stop surfaces of both the first equipment module and the second equipment module abut against the at least two stops.
